Europäisches Patentamt

European Patent Office

Office européen des brevets

(19)

(11) **EP 0 308 211 B1**

(12) **EUROPEAN PATENT SPECIFICATION**

(45) Date of publication and mention
of the grant of the patent:
**06.03.1996 Bulletin 1996/10**

(51) Int Cl.$^6$: **G01T 1/29**

(21) Application number: **88308519.3**

(22) Date of filing: **15.09.1988**

(54) **Ion beam position sensor**

Ionenstrahl-Stellungssensor

Capteur de position de faisceau ionique

(84) Designated Contracting States:
**CH DE FR GB IT LI NL**

(30) Priority: **16.09.1987 US 97500**

(43) Date of publication of application:
**22.03.1989 Bulletin 1989/12**

(73) Proprietor: **VARIAN ASSOCIATES, INC.**
**Palo Alto, CA 94303 (US)**

(72) Inventor: **Szajnowski, Wieslaw Jerzy**
**Guildford Surrey, GU1 2AX (GB)**

(74) Representative: **Cline, Roger Ledlie et al**
**EDWARD EVANS & CO.**
**Chancery House**
**53-64 Chancery Lane**
**London WC2A 1SD (GB)**

(56) References cited:
- **NUCLEAR INSTRUMENTS AND METHODS IN PHYSICS RESEARCH, vol. B6, 1985, pages 176-182, North-Holland, Amsterdam, NL; W.J. SZAJNOWSKI: "Extraction of information on a continuous ion beam from beam-induced shot noise"**
- **RADIO SCIENCE, vol. 20, no. 4, July-August 1985, pages 907-922, American Geophysical Union; M. SACHIDANANDA et al.: "Zdr measurement considerations for a fast scan capability radar"**

## Description

This invention relates to a signal processing apparatus for accurately determining the relative values of two random signals and, more particularly, to a signal processor utilizing weighted integration of log-ratios and channel switching for accurately estimating a parameter associated with a random process. The signal processor is particularly useful in apparatus for sensing the actual position of a scanned ion beam without intercepting or otherwise affecting the beam.

In the ion implantation of semiconductor devices, a beam of energetic ions is directed at the surface of a semiconductor wafer. The ions are embedded in the wafer and provide regions of desired conductivities. The beam is typically scanned in one or two dimensions by electrostatic or magnetic deflection to produce a uniform distribution of ions over the wafer surface. The ion implantation system utilizes different ion species, different acceleration voltages and different beam currents for different processes. In addition, the system is required to scan different size areas, depending on the size of the wafer being implanted. In spite of the numerous variables, it is required that the ion implantation system supply an accurate ion dosage to the wafer with a high degree of spatial uniformity.

In order to accurately control the ion implantation process, it is desirable to know the instantaneous position of the scanned ion beam in a plane perpendicular to the nominal beam axis. The beam position information can, for example, be used in a feedback system to control scanning. The scan voltage applied to the deflection plates or to the scan magnets provides some indication of the beam position. However, due to the variability of the ion species, beam currents and beam energies and a number of other factors, it is difficult to accurately relate scan voltage to beam position. One technique for determining actual beam position is to locate a Faraday cup or sensing wire in the beam path. This technique interferes with the beam and must be utilized during a calibration mode. As a result, it slows down overall system speed and is impractical.

It is known to sense the position of an ion beam by placing sensing electrodes on opposite sides of the beam. Noise modulation on the ion beam induces voltages on the sensing electrodes. When the electrodes are symmetrically positioned with respect to the beam, the deviation of the beam from its nominal axis can be determined by processing the random signals induced on the two electrodes. This technique is described, for example, in (1) M.S. Hodgart et al, "Remote Ion Beam Position Measurement From Random Beam Modulation," Inst. Phys. Conf., Ser. No. 38, 1978, Chapter 3, pp. 125-130; (2) W.J. Szajnowski, "Non-Destructive Techniques for Measuring the Parameters of Low-Energy Continuous Ion Beams," Proc., 4th Int. Conf. on Ion Implantation, Berchtesgaden, 1982; (3) W.J. Szajnowski, "Non-Destructive Ion Beam Position Monitors," ISIAT and IPAT Congress, Kyoto, September 1983; (4) W.J. Szajnowski, "Measurement of Ion Beam Parameters With Electrostatic Induction Electrodes," Vacuum, Vol. 34, Nos. 1-2, pp. 285-289, 1984; (5) W.J. Szajnowski, "Extraction Of Information On A Continuous Ion Beam From Beam-Induced Shot Noise," Nuclear Instruments and Methods in Physics Research, B6, 1985, pp. 176-182. This reference discloses signal processing apparatus for receiving electrical signals from a pair of sensors and for determining an estimate of a parameter from said signals, said apparatus comprising means for sampling the sensed signals at prescribed intervals and for converting the sensed signals to digital samples.

The present invention arranges that the sampling means comprises a first channel for sampling one of the sensed signals and a second channel for sampling the other of the sensed signals and further comprising channel switching means for switching the sensed signals between said first and second channels in first and second switch states and that the apparatus comprises means for calculating the estimate as a solution to the equation:

$$\text{estimate} = \tanh \left[ 1/2 \; \sum_{i=1}^{N} \; \ln \left| \frac{vi}{wi} \right| \cdot P_i \; / \; \sum_{i=1}^{N} P_i \right]$$

where N = number of sample pairs used in estimate, and

$P_i$ is a weight determined by $v_i$ and $w_i$, the switching means switching between the channels during calculation of the estimate so that the estimate is independent of mismatch in the signal processing means, said calculating means including a first programmable read only memory storing the function a first function of $v_i$ and $w_i$, said calculating means including a second programmable read only memory storing a second function of $v_i$ and $w_i$, wherein said absolute value of $v_i$ is connected to said first and second PROM array as an address and wherein said absolute value of $w_i$ is connected to said first and second PROM array as further address bits and wherein said first PROM array and second PROM array provide outputs to an accumulator for obtaining the ratio of:

The references listed above disclose functions for estimating the position of the beam based on the random signals induced on the two electrodes. The above-identified Szajnowski article in Vacuum discloses a closed-loop scan generator for use in an ion implanter to precisely tailor scan patterns. The above-identified Szajnowski article in Nuclear Instruments and Methods discloses a maximum likelihood estimator for determining the position of an ion beam and also a sub-optimum estimator. The same article also suggests applications of the beam position measurement including alignment of the beam centroid, implementing an optimum scan pattern, stabilization of beam energy, monitoring the tilt angle of the beam's cross-section, monitoring the beam expansion during transport, and monitoring the stability and statistical properties of ion sources. A simple version of a log-ratio estimator without weighting has been described by V.N. Bringi et al in "Statistical Properties of the Dual-Polarization Differential Reflectivity ($Z_{DR}$) Radar Signal," IEEE Trans. Geoscience And Remote Sensing, Vol. GE-21, No. 2, April, 1983, pp. 215-219 (see equation (8)).

One source of error in practical dual-channel signal processors is the mismatch between channels of both amplitude and phase response. The two channels can be equalized to some extent by trimming. However, trimming over a several megahertz frequency band is difficult. It is well known that the instrumentation error due to channel mismatch can be reduced by channel switching (see, for example, M. Sachidananda et al, "$Z_{DR}$ Measurement Considerations For a Fast Scan Capability Radar," Radio Science, Vol. 20, No. 4, pp. 907-922, July-Aug. 1985, Fig. 16b). However, the instrumentation error due to channel mismatch is not entirely eliminated when used with prior art signal processors. The Radio Science article also discloses the idea of channel switching.

An example of the invention will now be described, reference being made to the accompanying drawings which are incorporated herein by reference and in which:

FIG. 1 is a schematic diagram of an ion implantation system including apparatus for sensing beam position ;
FIG. 2 illustrates a preferred electrode structure for beam sensing;
FIG. 3 is a general block diagram of a sensing and signal processing system ;
FIG. 4 is a block diagram of a sub-optimum signal processor in accordance with the invention;
FIG. 5 is a block diagram of another embodiment of a sub-optimum signal processor in accordance with the present invention;
FIG. 6 is a block diagram of yet another embodiment of a sub-optimum signal processor in accordance with the invention; and
FIG. 7 is a graphic representation of the region of acceptance for the signal processor illustrated in FIG. 6.

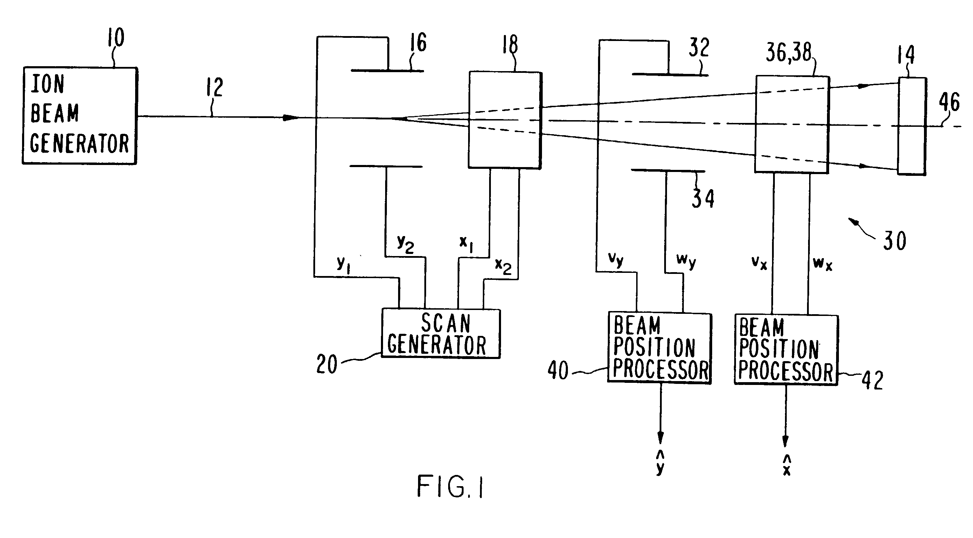

A block diagram of a scanned ion beam system utilizing a beam position monitor is illustrated in FIG. 1. An ion beam generator 10 directs an ion beam 12 at a target 14 which is typically a semiconductor wafer. The ion beam generator 10 includes suitable elements for producing a well-defined beam of ions of a prescribed species and energy. In accordance with well-known techniques, the ion beam generator 10 typically includes an ion source, a mass analyzer magnet and a resolving aperture for separating undesired species, an acceleration tube for accelerating the ions and optical elements for focusing the beam in the target plane.

The beam 12 is scanned in the y direction by a pair of electrostatic deflection plates 16 and is scanned in the x direction by a pair of electrostatic deflection plates 18, both of which are positioned along the beam path. Y axis scan voltages $y_1$, $y_2$ and x axis scan voltages $x_1$, $x_2$ are supplied by a scan generator 20. The scan voltages are typically ramp voltages which produce a conventional raster scan over the area of the target 14. In a typical serial ion implantation system, a scan rate of 1,000 Hz is utilized.

Two-dimensional electrostatic scanning of the ion beam 12 is illustrated in FIG. I. Alternatively, the beam 12 may be scanned in one dimension by magnetic fields, while mechanical movement of the target 14 is utilized to distribute the beam over the target area. In a typical batch ion implantation system, a magnetic scan rate of about 1 Hz is utilized.

A beam position monitor in accordance with the present invention includes a pair of y axis sensing electrodes 32, 34 and a pair of x axis sensing electrodes 36, 38. The sensing electrodes 32, 34 supply sensed signals $v_y(t)$ and $w_y(t)$, respectively, to a y axis beam position processor 40, and sensing electrodes 36, 38 supply sensed signals $v_x(t)$ and $w_x(t)$, respectively, to an x axis beam position processor 42. The beam position processors 40 and 42 process the sensed signals and provide estimates $\hat{y}$ and $\hat{x}$, respectively, of the beam position in each direction.

As the beam 12 passes between the sensing electrodes, voltages are induced on each of the electrodes. The voltages arise from natural random modulation within the beam as described in the prior art. When the electrodes are symmetrically positioned with respect to a beam axis 46 and the beam is passing along the axis 46 (undeflected), equal voltages are induced on electrodes 32, 34 and on electrodes 36, 38. As the beam 12 is deflected closer to one electrode, the induced voltage on that closer electrode increases and the induced voltage on the other more distant electrode decreases. Thus, the magnitudes of the voltages induced on each pair of electrodes can be used to estimate the position of the beam 12 relative to the axis 46. The electrodes 32, 34 sense the beam position in the y direction while the electrodes 36, 38 sense the position of the beam 12 in the x direction.

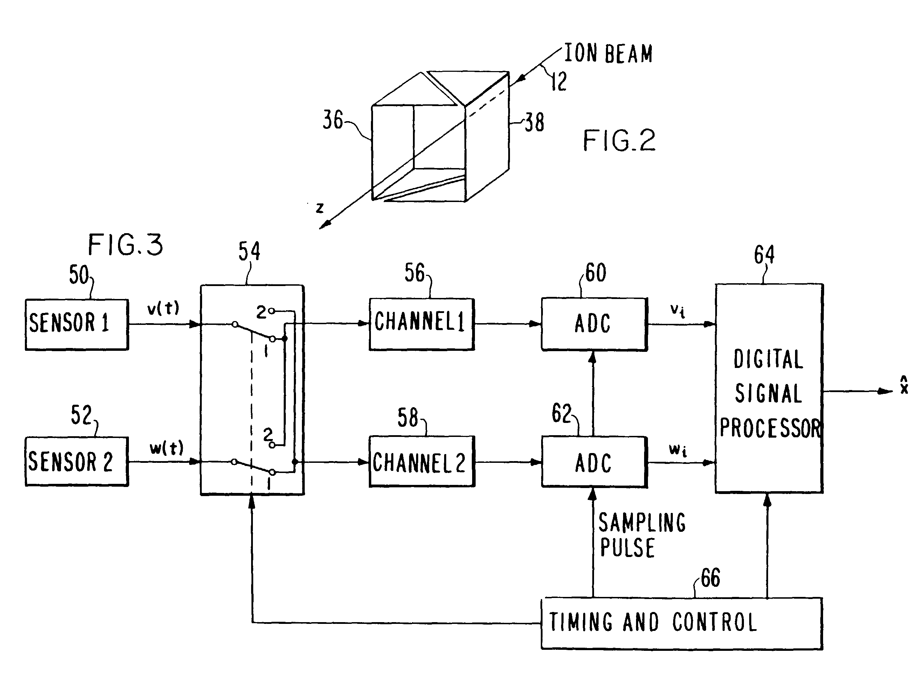

A preferred sensing electrode structure is shown in FIG. 2. It consists of a shell of arbitrary cross-section (square, rectangular, circular) split diagonally to define two electrodes. In the example of FIG. 2, the electrodes 36 and 38 have a square cross-section. The configuration which surrounds the beam 12 provides substantially better linearity and sensitivity than a pair of parallel plates. Each pair of electrodes senses the bean position along one axis, and two pairs of electrodes with a relative orientation of 90° are utilized to sense the beam position in two dimensions.

A system for accurately estimating a parameter x associated with a random process is illustrated in block diagram form in FIG. 3. A pair of sensors 50 and 52 sense the desired random phenomena and supply signals v(t) and w(t), respectively, to a channel switch 54. The outputs of the channel switch 54 are supplied to a first channel 56 and to a second channel 58. The channel switch 54 is an electronically controlled switch having two states. In state 1, signal v (t) from sensor 50 is supplied to the first channel 56 and signal w(t) from sensor 52 is supplied to second channel 58. In state 2, the connections are reversed and signal v(t) from sensor 50 is supplied to second channel 58 and signal w (t) from sensor 52 is supplied to first channel 56. In accordance with well-known techniques, each of channels 56 and 58 typically includes a low-noise, wide band preamplifier, a gain control stage, a low pass filter and a buffer amplifier for driving an analog-to-digital converter. The outputs of channels 56 and 58 are supplied to analog-to-digital converters 60 and 62, respectively, which sample the sensed signals and provide samples $v_i$ and $w_i$ to the digital signal processor 64. The output of the digital signal processor 64 is an estimate of the parameter being measured. The system further includes a timing and control unit 66 which supplies a switch control signal to channel switch 54, sampling pulses to analog-to-digital converters 60 and 62 and timing and control signals to digital signal processor 64.

For ion beam position sensing the sensors 50 and 52 correspond to the beam sensing electrodes shown and described hereinabove. One processor system as shown in FIG. 3 is required for x axis beam position sensing, and another system is required for y axis beam position sensing. Thus, for processor 40 of FIG. 1, sensors 50 and 52 correspond to electrodes 32 and 34, while for processor 42, the sensqrs 50 and 52 correspond to electrodes 36 and 38. For other applications, the sensors 50 and 52 may be optical position sensors, antennas, microphones or some other type of transducers. The outputs of the sensors 50 and 52 are random electrical signals v(t) and w(t).

Digital signal processing involves quantization of input signals, v(t) and w(t). If averages, or correlations are computed from quantized samples, $v_i$ and $w_i$, the roundoff will increase the rms error of the estimate and also may introduce some bias to the estimate. For many signals encountered in practical situations, however, theoretical studies have shown that the biasing effects of quantization average out.

The digital samples, $v_i$ and $w_i$, obtained at the outputs of the two ADCs are the quantized versions of the two signals v(t) and w(t) which can be expressed as

$$v_i = (1 + \chi S_E/A_x)s_i + n_{1i} \tag{1}$$

$$w_i = (1 - \chi S_E/A_x)s_i + n_{2i} \tag{2}$$

where:

x - coordinate of the beam centroid, $|x| \leq A_x$ ;
$S_E$ - sensitivity of the electrode system, $(S_E < 1)$ ;
$2A_x$ - width of the working aperture of the system;
$s_i$ - sample of the beam-induced signal when x=0;
$n_{1i}$ - samples of thermal noise in channel 1;
$n_{2i}$ - samples of thermal noise in channel 2;

For practical designs of electrode system, the sensitivity, $S_E$, will vary from approximately 0.2 (for short systems) to 0.7.

It is assumed that the noise samples, $n_{1i}$ and $n_{2i}$, can be modelled as two mutually independent discrete-time Gaussian processes with zero means and rms values equal to $\sigma_n$. The signal samples, $s_i$, represent a discrete-time random process with zero mean and rms value equal to $\sigma_s$.

The equations (1) and (2) are valid for electrode systems with linear characteristics. For other electrode systems, particularly short systems, the above equations will be modified as follows:

$$v_i = [1 + \Phi(x/A_x)]s_i + n_{1i} \tag{3}$$

$$W_i = [1 - \Phi(x/A_x)]s_i + n_{2i} \tag{4}$$

where $\Phi(x/A_x)$ is a nonlinear function describing the electrode characteristics.

In such cases, the sensitivity varies over the electrode aperture. Typically for short electrode systems, the sensitivity of 0.1 at the central position rises to 0.3 for the extreme beam positions.

Assume that an ion beam is scanned linearly with a period $T_s$ and an amplitude $X_s$. Theoretical analysis has shown that the rms error, $\sigma_x$, of a position estimate $\hat{x}_j$, computed at the time instant $t_j$, can be expressed as

$$\sigma_{\hat{x}} = \chi_s \sqrt{1 + S_E^{-2}}/[2d\sqrt{2N\eta}] \tag{5}$$

where

$X_s$ - scan amplitude;
$S_E$ - sensitivity of the electrode system;

d - signal-to-noise ratio (SNR), defined by $d = \sigma_s/\sigma_n$;
N - number of independent sample pairs, $v_i$ and $w_i$, used for estimation;
$\eta$ - efficiency of an estimation procedure implemented.

The efficiency, $\eta$, is defined by the ratio

$$\eta = \sigma_{\hat{x}_o}^2 / \sigma_{\hat{x}_i}^2 \tag{6}$$

where $\sigma_{\hat{x}o}$ and $\sigma_{\hat{x}1}$ are the rms errors of the optimum procedure and the one implemented, respectively. Generally, the efficiency, $\eta$, of procedures attractive from a practical viewpoint is not less than 0.5 and may be even as high as 0.9.

Consider two consecutive position estimates, $\hat{x}_j$ and $\hat{x}_{j+1}$, computed at the time instants $t_j$ and $t_{j+1}$. In practice, the time difference between two such samples should be so chosen as to obtain small values of rms errors, $\sigma_{\hat{x}}$, with reference to the sampling distance $\Delta X$.

If we assume that the spectrum of beam-induced signals, $v(t)$ and $w(t)$, is limited by $B_s$ and that the Nyquist sampling is used, the the number, N, of independent pairs, $v_i$ and $w_i$, can be expressed as

$$N = B_s T_s \Delta x/x_s \tag{7}$$

The above results can be combined to establish the minimum value of the signal/noise ratio, $d_{min}$, required to obtain $N_x$ reliable equidistant position samples over the $(0, X_s)$ interval. Assuming that $\sigma_{\hat{x}} = 0.1\Delta X$, the value of $d_{min}$ is equal to

$$d_{min} = 3.5 \sqrt{1 + S_E^{-2}} \sqrt{F_s/B_s} \; \eta^{-\frac{1}{2}} N_x^{3/2} \tag{8}$$

where $F_s$ denotes the scanning frequency.

To determine the typical values of $d_{min}$ required, let us consider two simple examples.

Example 1:

$S_E =$ 0.6 (linear electrode system)
$F_s =$ 500 Hz
$B_s =$ 2 MHz
$\eta =$ 1 (optimum signal processor).

For the above set of parameters, $d_{min}$ equals

$$d_{min} = 0.11 \; N_x^{3/2} \tag{9}$$

As seen, to obtain 20 reliable position samples along $X_s$, the required signal/noise ratio has to be greater than 10. For $N_x = 40$, the value of $d_{min}$ rises to 28.

Example 2:

$S_E =$ 0.2 (short electrode system)
$F_s =$ 1 Hz
$B_s =$ 2 MHz
$\eta =$ 0.5 (sub-optimum signal processor).

In this case, the required value of $d_{min}$ equals

$$d_{min} = 0.018 \; N_x^{3/2} \tag{10}$$

To obtain 100 reliable position samples along $X_s$, $d_{min}$ has to be about 18.

A sub-optimum estimator described previously in the literature is of the form

$$\hat{x}_s = \sum_{i=1}^{N} \left[ v_i^2 - w_i^2 \right] \Big/ \sum_{i=1}^{N} \left[ v_i + w_i \right]^2 \qquad (11)$$

where N is the number of sample pairs used for estimation.

For the purpose of digital processing, equation (11) can be expressed in an equivalent form

$$\hat{x}_s = \sum_{i=1}^{N} \frac{v_i - w_i}{v_i + w_i} \cdot P_i \Big/ \sum_{i=1}^{N} P_i \qquad (12)$$

where

$$P_i = [v_i + w_i]^2 \qquad (13)$$

This is essentially a weighted average of a commonly used difference/sum ratio estimator. The basic advantage offered by the form of equation (12) is that in a digital processor, the difference/sum values can be stored in a PROM (need not be computed) and the weights $P_i$ can be represented by a small number of bits (four or less). Depending on the number of bits to represent $P_i$, the algorithm performance will vary.

It is possible to derive yet another sub-optimum estimator by employing the identity.

$$\frac{a-b}{a+b} = \tanh \left[ \frac{1}{2} \ln \left( \frac{a}{b} \right) \right], \ a,b > o \qquad (14)$$

where tanh(.) denotes the hyperbolic tangent function. Replacing the difference/sum ratio in equation (12) by the log-ratio from equation (14) leads to a new sub-optimum estimator of the form

$$\hat{x}_\ell = \tanh \left[ \frac{1}{2} \sum_{i=1}^{N} \ln \frac{|v_i|}{|w_i|} \cdot P_i \Big/ \sum_{i=1}^{N} P_i \right] \qquad (15)$$

with $P_i$ defined by equation (13). The estimator of equation (15) is essentially a weighted average of log-ratio values, followed by a nonlinear transformation.

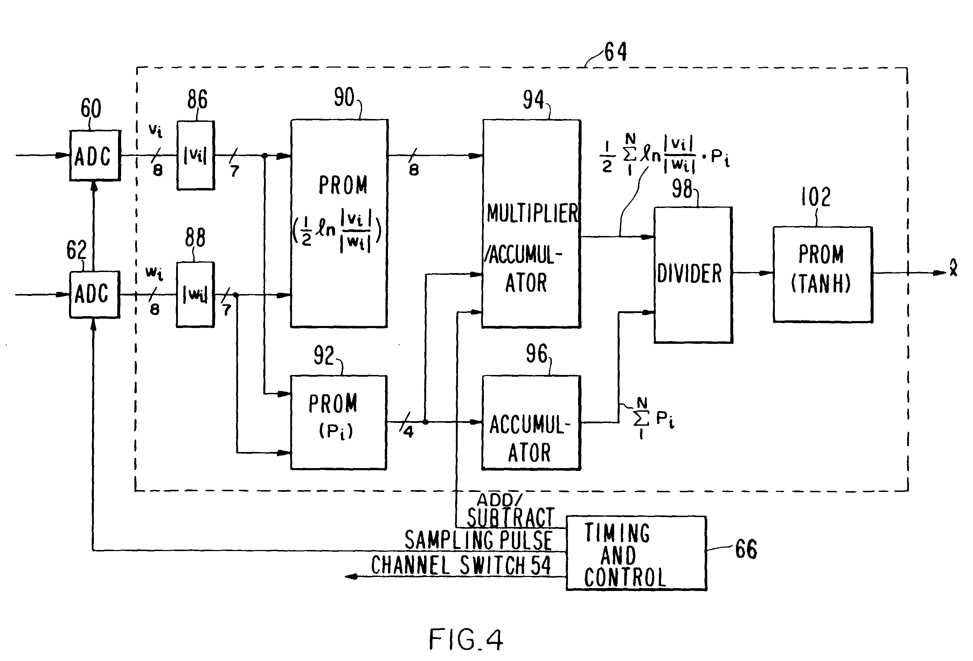

One possible digital implementation of equation (15) is shown in FIG. 4. The elements contained within the dashed line represent the digital signal processor 64 of FIG. 3. The output samples $v_i$ from ADC 60 are supplied to the input of an absolute value circuit 86, and the output samples $w_i$ from ADC 62 are supplied to an absolute value circuit 88. The absolute value of $v_i$ from circuit 86 is supplied to address inputs of a programmable read only memory (PROM) 90 and to address inputs of a PROM 92. The absolute value of $w_i$ from circuit 88 is supplied to additional address inputs of PROM 90 and to additional address inputs of PROM 92. The PROM 90 provides at its output the value of 1/2 1n$|v_i|/|w_i|$. The PROM 92 contains the values of the $P_i$ in accordance with equation (13). The outputs of PROM 90 are supplied to one input of a multiplier/accumulator 94. The outputs of PROM 92 are supplied to the other input of multiplier/accumulator 94 and to the input of an accumulator 96. An add/subtract control line is coupled from timing and control unit 66 to multiplier/accumulator 94 for controlling whether the computed value for each sample is added to or subtracted from the accumulated total in accordance with the state of channel switch 54. Because of the logarithmic form of equation (15), changing the sign is equivalent to exchanging the arguments $|v_i|$ and $|w_i|$ (i.e., channel switching) at the output. The outputs of multiplier/accumulator 94 and accumulator 96 are supplied to the two inputs of a divider 98. The output of divider 98 is supplied to the address inputs of a PROM 102 which stores the values of tanh(Z) where Z is the value at its input. The output of PROM 102 is the beam position estimate.

The computation of the nonlinear functions: log ratio and hyperbolic tangent, is replaced by a table "look-up" operation (PROM 90 and PROM 102); an additional table (PROM 92) is used for weight computation. It is assumed that the log-ratio values, stored in PROM 90 are represented by 8-bit numbers, and the values of weights $P_i$, stored in FROM 92, are represented by a small number of bits, typically four or less.

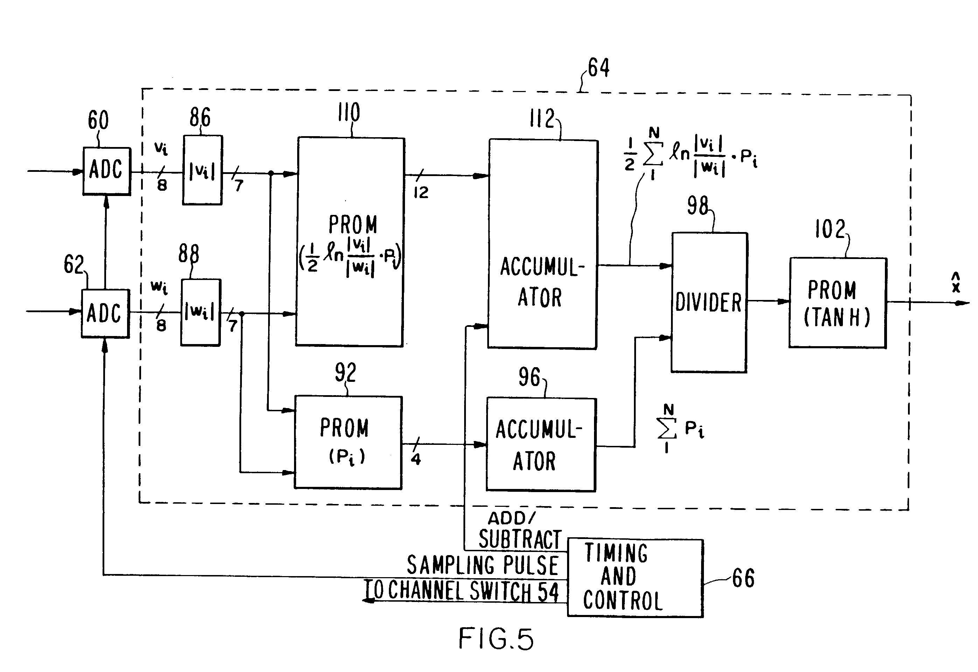

Another implementation of the equation (15) is shown in FIG. 5. This implementation is similar to the implementation shown in FIG. 4 and like elements have the same reference numerals. In this configuration, the PROM 90 of FIG. 4 is replaced with a PROM 110 which stores the log-ratios 1/2 1n $|v_i|/|w_i|$ multiplied by the values of the weights $P_i$. This permits the multiplier/ accumulator 94 of FIG. 4 to be replaced by an accumulator 112. Since the multiplication has been eliminated, the configuration of FIG. 5 provides faster data throughput.

The processor for implementing equation (15) assumes an extremely simple form when binary coding for $P_i$ is used.

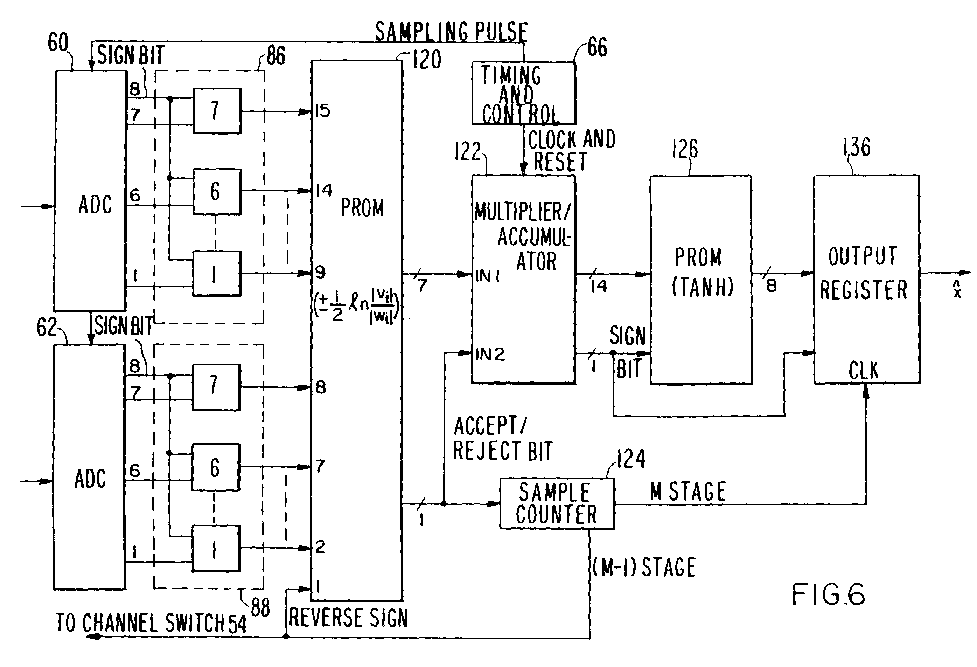

Such a processor is illustrated in FIG. 6. The samples $v_i$ from analog-to-digital converter 60 and samples $w_i$ from analog-to-digital converter 62 are supplied through absolute value circuits 86 and 88, respectively, to a PROM 120. One set of outputs from PROM 120 consisting of seven bits representing $\pm 1/2$ ln $|v_i|/|w_i|$ is coupled to one set of inputs of a multiplier/accumulator 122. A second output from the PROM 120 consisting of one bit representing the accept/reject bit, is coupled to a second input of the multiplier/accumulator 122 and is also coupled to the input of a sample counter 124 having M stages. The outputs of the multiplier/accumulator 122 are coupled to a PROM 126 which stores the hyperbolic tangent of the input values. The output of PROM 126 consisting of eight bits, is coupled to an output register 130. The output of register 130 is the desired position estimate $\hat{x}$, consisting of nine bits. A sign bit from the multiplier/accumulator 122 is coupled to an input of PROM 126 and to an input of register 130. The output of the Mth, or last stage of sample counter 124 is coupled to the clock input of output register 130. The output of the (M-1) stage of sample counter 124 is coupled to an input of PROM 120 and is coupled to the control input of channel switch 54 (FIG. 3). The timing and control unit 66 provides a sampling pulse to the analog-to-digital converters 60 and 62 and clock and reset signals to the multiplier/accumulator 122.

In one example of the processor of FIG. 6, the analog-to-digital converters 60 and 62 were flash 8-bit, a/d converters type TS8308, the absolute value circuits were Exclusive-Or gates type 7486 in Exclusive-Nor configuration, PROMS 120 and 126 were 32K words x 8 bits type 27256, multiplier/accumulator 122 was an 8-bit x 8-bit type 1008, sample counter 124 was a 14-stage binary counter type 4020 and output register 130 was a 9-bit D-type register type 39C821. It will be understood that the above components are given by way of example only.

The PROM 120 receives $|v_i|$ and $|w_i|$ and supplies at its output

1. $+1/2$ ln $|v_i|/|w_i|$ or $-1/2$ ln $|v_i|/|w_i|$ when the channels have been switched according to the sign reversing bit supplied to PROM 120 from the (M-1) stage of sample counter 124;
2. An accept/reject bit which is 1 if

$$|v_i|+|w_i|\geq L$$

where L is a threshold level, and

$$0 < |v_i| < 127$$

$$0 < |w_i| < 127$$

for an 8-bit ADC.

Otherwise, the accept/reject bit is 0.

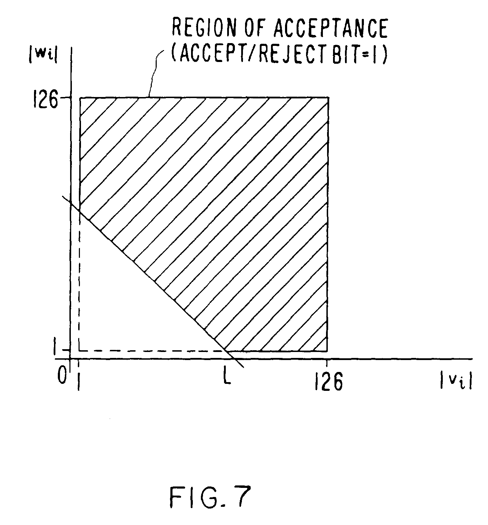

The region of acceptance is illustrated in graphic form in FIG. 7. The example shown is for an 8-bit analog-to-digital converter where threshold level L is typically in the range between 64 and 96. The maximum value of 126 is selected for an 8-bit ADC since when the maximum output value 127 is provided, the input signal may exceed the range of the ADC. Similarly, lower values are rejected in order to reduce the effects of fading and to ignore values where the ADC has low conversion accuracy.

In operation of the processor of FIG. 6, signals v(t) and w(t) are converted to 8-bit digital words by converters 60 and 62 and their absolute values (7-bit words) are computed by circuits 86 and 88. The address of PROM 120 consists of 7 bits representing the absolute value of $v_i$, another 7 bits representing the absolute value of $w_i$ and 1 sign reversing bit from the (M-1) stage of the sample counter 124. The outputs of the PROM 120 are 7 bits to represent $\pm 1/2$ ln $|v_i|/|w_i|$, where the sign $\pm$ is defined by the sign reversing bit. The PROM 120 also supplies a 1-bit accept/reject signal as described above. When the accept/reject bit is 1, then the multiplier/accumulator 122 adds the value of $\pm 1/2$ ln $|v_i|/|w_i|$ at the output of PROM 120 to its accumulated content. When the accept/reject bit is 0, then the output of PROM 120 is ignored. The sample counter 124 increments its state only when the accept/reject bit is 1. The total number of states in sample counter 124 is equal to the number of samples required for a position estimate. Thus, for example, when 100 samples are required to make a position estimate, the sample counter 124 has 100 states. The channel switching and sign reversing signal is obtained from the (M-1) stage of the sample counter 124. As a result, channel switch 54 is in state 1 during the first half of the measurement cycle and is in state 2 during the second half of the measurement cycle (or vice versa). In the above example, channel switch 54 would be in state 1 for 50 samples, and in state 2 for 50 samples. When the Mth stage of counter 124 changes its state, then the output of PROM 126 is transferred to the output register 130, thereby updating the value of the position estimate $\hat{x}$. In the above example, the Mth stage of counter 124 changes state after 100 samples.

In this case, the multiplication by $P_i$ reduces to addition of a log-ratio value, when $P_i = 1$, and rejecting the sample pairs for which $P_i = 0$. Moreover, if the number of accepted pairs (for which $P_i = 1$) is fixed in advance, then the division can be substituted by a scaling operation performed on the sum of accumulated log-ratios. It should be pointed out, however, that if a number of accepted sample pairs is predetermined, then the total number of sample pairs passing through the processor to achieve that predetermined number will vary, depending on the statistical properties of signals being processed. In a practical system, the hyperbolic tangent conversion performed by PROM 126 can be combined with a calibration map of an electrode system, so that no additional memory is needed.

Although the performance of the log-ratio estimator of equation (15) is expected to be close to that of the sub-optimum estimator of equation (11), the log-ratio estimator can be used also to correct for any gain mismatch that may occur between the two analog channels prior to analog/digital conversion. To see how the gain mismatch affects the accuracy of a position measurement, assume that an ion beam is at central position and the two samples, $v_i$ and $w_i$, have passed through two channels with gains $G_v$ and $G_w$, respectively. If $G_v$ and $G_w$ are not equal, then the beam position estimated from the difference/sum ratio will differ from zero by $(G_v - G_w)/(G_v + G_w)$ even if no noise is present. To reduce this error, channel switching has been suggested in the literature (see <u>Radio Science</u>, Vol. 20, No. 4, pp. 907-922, July-Aug. 1985, Fig. 16b). If, however, channel switching is used in conjuction with the log-ratio sub-optimum estimator as shown in FIG. 3 and described hereinabove, then the resulting procedure is totally independent of the channel gain mismatch. This extremely useful feature of the log-ratio estimator follows from the properties of a logarithmic function. The processor implementing the log-ratio estimator and incorporating the channel switching (FIG. 3) will be referred to as the gain-mismatch tolerant processor (or GMT processor).

The GMT processor estimates an ion beam position during the two cycles:

1. cycle 1 - a signal induced on the electrode 1 passes through channel 1 and a signal induced on the electrode 2 passes through channel 2; the processor adds the log-ratio values.
2. cycle 2 - a signal induced on the electrode 1 passes through channel 2 and a signal induced on the electrode 2 passes through channel 1; the processor adds the log-ratio values with reversed signs.

When the two cycles have been terminated, the hyperbolic tangent operation is performed on the resulting sum of log-ratios.

To see why the GMT processor shown in FIG. 6 is insensitive to any gain mismatch between the two channels, assume that only one sample pair $(v_1, w_1)$ is processed during cycle 1 and another sample pair $(v_2, w_2)$ is processed during cycle 2. Next, suppose that the gains of the two channels are $G_v$ and $G_w$, respectively. During cycle 1, PROM 120 supplies the value of $1/2 \ln G_v|v_1|/ G_w|W_1|$ to the multiplier/accumulator 122. Next, the inputs of the two channels are switched and PROM 120 supplies values with reversed polarity. As a result, during cycle 2 a value of $-1/2 \ln G_v|w_2|/ G_w|v_2|$ is added to the multiplier/accumulator 122. The result of those two operations equals $1/2 \ln |v_1|/|w_1| + 1/2 \ln |v_2|/|w_2|$ which is the correct sum of the two log-ratios and which is not effected by the different channel gains $G_v$ and $G_w$. Moreover, since the analog-to-digital converters 60 and 62 are within the channels being switched, their different gains (scale factors) do not affect the accuracy of a position measurement.

While there has been shown and described what is at present considered the preferred embodiments of the present invention, it will be obvious to those skilled in the art that various changes and modifications may be made therein without departing from the scope of the present invention as defined by the appended claims.

## Claims

1. Ion beam locating apparatus for receiving electrical signals v(t) and w(t) from a pair of ion beam sensors and for determining an estimate of a parameter from said signals, said apparatus comprising:

means (60-66) for sampling the sensed signals v(t), w(t) at prescribed intervals and for converting the sensed signals to digital samples $v_i$, $w_i$, characterised in that said sampling means comprises a first channel (56) for sampling one of the sensed signals and a second channel (58) for sampling the other of the sensed signals and further comprising channel switching means (54) for switching the sensed signals v(t) and w(t) between said first and second channels in first and second switch states and in that the apparatus comprises means (90, 102) for calculating the estimate as a solution to the equation:

$$\text{estimate} = \tanh \left[ 1/2 \sum_{i=1}^{N} \ln \left| \frac{v_i}{w_i} \right| \cdot P_i \Big/ \sum_{i=1}^{N} P_i \right]$$

where
N = number of sample pairs used in estimate, and
$P_i$ is a weight determined by $v_i$ and $w_i$,
the switching means (54) switching between the channels during calculation of the estimate so that the estimate is independent of mismatch in the signal processing means, said calculating means including a first program-

EP 0 308 211 B1

mable read only memory (90) storing a first function of $v_i$ and $w_i$, said calculating means including a second programmable read only memory (102) storing a second function of $v_i$ and $w_i$, wherein said absolute value of $v_i$ is connected to said first and second PROM array as an address and wherein said absolute value of $w_i$ is connected to said first and second PROM array as further address bits and wherein said first PROM array and second PROM array provide outputs to an accumulator for obtaining the ratio of:

$$\frac{\frac{1}{2}\sum_{i}^{n}\ln\frac{|v_i|}{|w_i|}\cdot P_i}{\sum_{i}^{n}P_i}$$

2.  Apparatus as claimed in claim 1, wherein said calculating means includes programmable read only memory for storing the function tanh.

3.  Apparatus as claimed in claim 2, wherein said first function is the function 1/2 1n $|v_i|/|w_i|$.

4.  Apparatus as claimed in claim 2, wherein said second function is the function $P_i$ 1/2 1n$|v_i|/|w_i|$.

5.  Signal processing apparatus as claimed in any one of claims 1 to 4, wherein said sampling means includes a first analog-to-digital converter for sampling v(t) and producing digital samples $v_i$ and a second analog-to-digital converter for sampling w(t) and providing digital samples $w_i$.

6.  Signal processing apparatus as claimed in any one of claims 1 to 5 including means for providing $P_i$ as a binary value of 1 or 0.

7.  Apparatus as claimed in claim 6, wherein said means for providing comprises means for determining $P_i$ to have a value of 1 if the value $|v_i| + |w_i|$ is greater than a predetermined threshold level, $|v_i|$ is within a predetermined range and $|w_i|$ is within a predetermined range, and a value of 0 otherwise.

8.  Signal processing apparatus as claimed in claim 7, wherein the calculating means includes first programmable read only memory means for storing the values of 1/2 1n $|v_i|/|w_i|$ and the values of the weights $P_i$ and a multiplier/accumulator for accumulating the values of 1/2 1n $|v_i|/|w_i|$ when $P_i$ has a value of 1.

9.  Signal processing apparatus as claimed in claim 8, wherein the calculating means further includes second programmable read only memory means responsive to the outputs of the multiplier/ accumulator for storing the hyperbolic tangent function and counter means for counting the samples for which $P_i$ has a value of 1, said counter means indicating that the output of said second programmable read only memory means is a valid estimate when a predetermined sample count is reached.

10. Signal processing apparatus as claimed in any one of claims 1 to 9, wherein said channel switching means is responsive to said counter means to change states after one half of the predetermined sample count is reached.

11. Signal processing apparatus as claimed in claim 10, wherein said channel switching means further includes means for changing the sign of 1/2 1n $|v_i|/|w_i|$ in accordance with said first and second switch states.

**Patentansprüche**

1.  Vorrichtung zur Ionenstrahllokalisierung zum Empfang elektrischer Signale v(t) und w(t) von einem Ionenstrahlsensorpaar und zur Bestimmung eines Schätzwertes eines Parameters aus diesen Signalen, mit

    Einrichtungen (60 - 66) zum Abtasten der erfaßten Signale v(t), w(t) in vorgeschriebenen Intervallen und zum Wandeln der erfaßten Signale zu digitalen Abtastwerten $v_i$, $w_i$,
    dadurch gekennzeichnet, daß die Abtasteinrichtung einen ersten Kanal (56) zum Abtasten eines der erfaßten Signale und einen zweiten Kanal (58) zum Abtasten des anderen der erfaßten Signale und desweiteren eine

9

Kanalumschalteinrichtung (54) zum Umschalten der erfaßten Signale v(t) und w(t) zwischen dem ersten und dem zweiten Kanal in einen ersten und zweiten Schaltzustand umfaßt, und daß die Vorrichtung eine Einrichtung (90, 102) zur Berechung des Schätzwertes als Lösung der nachstehenden Gleichung umfaßt:

$$\text{Sch\"atzwert} = \tanh\left[1 / 2\sum_{i=1}^{N} \ln \frac{|vi|}{|wi|} \cdot P_i / \sum_{i=1}^{N} P_i\right]$$

wobei N = Anzahl der in der Schätzung verwendeten Abtastwertepaare und
$P_i$ ein durch $v_i$ und $w_i$ bestimmtes Gewicht ist, und daß
die Umschalteinrichtung (54) während der Berechnung des Schätzwertes zwischen den Kanälen umschaltet, so daß der Schätzwert unabhängig ist von Nichtübereinstimmungen in der Signalverarbeitungseinrichtung,
die Berechnungseinrichtung einen ersten programmierbaren Festwertspeicher (90) zum Speichern einer ersten Funktion von $v_i$ und $w_i$ enthält,
die Berechnungseinrichtung einen zweiten programmierbaren Festwertspeicher (102) zum Speichern einer zweiten Funktion von $v_i$ und $w_i$ enthält, in der der Absolutwert von $v_i$ mit der ersten und zweiten PROM-Anordnung als eine Adresse verbunden ist, und in der der Absolutwert von $w_i$ mit der ersten und zweiten PROM-Anordnung als weitere Adreßbits verbunden ist, und in der die erste und die zweite PROM-Anordnung Ausgänge an einen Akkumulator liefern, um das Verhältnis

$$\frac{1 / 2\sum_{1}^{n} \ln \frac{|vi|}{|wi|} \cdot P_i}{\sum_{1}^{n} P_i}$$

zu erhalten.

2. Vorrichtung nach Anspruch 1, in der die Berechnungseinrichtung einen programmierbaren Festwertspeicher zum Speichern der Funktion tanh enthält.

3. Vorrichtung nach Anspruch 2, in der die erste Funktion die Funktion $1/2$ 1n $|v_i|/|w_i|$ ist.

4. Vorrichtung nach Anspruch 2, in der die zweite Funktion die Funktion $P_i$ $1/2$ 1n $|v_i|/|w_i|$ ist.

5. Signalverarbeitungsvorrichtung nach einem der Ansprüche 1 bis 4, in der die Abtasteinrichtung einen ersten Analog-/Digitalwandler zum Abtasten von v(t) und zum Erzeugen digitaler Abtastwerte $v_i$ und einen zweiten Analog-/Digitalwandler zum Abtasten von w(t) und zum Bereitstellen digitaler Abtastwerte $w_i$ enthält.

6. Signalverarbeitungsvorrichtung nach einem der Ansprüche 1 bis 5, die eine Einrichtung zum Bereitstellen von $P_i$ als einen Binärwert von 1 oder 0 enthält.

7. Vorrichtung nach Anspruch 6, in der die Einrichtung zum Bereitstellen von $P_i$ eine Einrichtung zur Bestimmung von $P_i$ umfaßt, so daß $P_i$ einen Wert von 1 hat, wenn der Wert $|v_i| + |w_i|$ größer ist als ein vorgegebener Schwellenpegel, $|v_i|$ innerhalb eines vorgegebenen Bereichs liegt und $|w_i|$ innerhalb eines vorgegebenen Bereichs liegt und sonst einen Wert von 0 hat.

8. Signalverarbeitungsvorrichtung nach Anspruch 7, in der die Berechnungseinrichtung eine erste programmierbare Festwertspeichereinrichtung zum Speichern der Werte von $1/2$ 1n $|v_i|/|w_i|$ und der Werte der Gewichte $P_i$ und einen Multiplizierer/Akkumulator zum Akkumulieren der Werte von $1/2$ 1n $|v_i|/|w_i|$ enthält, wenn $P_i$ den Wert 1 hat.

9. Signalverarbeitungsvorrichtung nach Anspruch 8, in der die Berechnungseinrichtung desweiteren eine zweite programmierbare Festwertspeichereinrichtung enthält, die auf die Ausgangssignale des Multiplizierers/Akkumulators anspricht, zum Speichern der hyperbolischen Tangensfunktion sowie eine Zählereinrichtung zum Zählen der Abtastwerte, für die $P_i$ den Wert 1 hat, wobei die Zählereinrichtung angibt, daß der Ausgang der zweiten programmierbaren Festwertspeichereinrichtung ein gültiger Schätzwert ist, wenn ein vorgegebener Abtastwert-Zählwert erreicht ist.

10. Signalverarbeitungsvorrichtung nach einem der Ansprüche 1 bis 9, in der die Kanalumschalteinrichtung auf die Zählereinrichtung anspricht, um die Zustände zu ändern, nachdem eine Hälfte des vorgegebenen Abtastwerte-Zählwertes erreicht ist.

11. Signalverarbeitungseinrichtung nach Anspruch 10, in der die Kanalumschalteinrichtung desweiteren eine Einrichtung zur Änderung des Vorzeichens von 1/2 1n $|v_i|/|w_i|$ gemäß den ersten und zweiten Schaltzuständen enthält.

## Revendications

1. Appareil de localisation de faisceau ionique pour recevoir des signaux électriques v(t) et w(t) en provenance d'une paire de capteurs de faisceaux ioniques et pour déterminer l'estimation d'un paramètre à partir desdits signaux, ledit appareil comprenant:

un moyen (60-66) pour échantillonner les signaux détectés v(t), w(t) à des intervalles prédéterminés et pour convertir les signaux détectés en échantillons numériques vi, wi, caractérisé en ce que ledit moyen d'échantillonnage comprend un premier canal (56) pour échantillonner l'un des signaux détectés et un second canal (58) pour échantillonner l'autre des signaux détectés et comprenant en outre un moyen (54) de commutation de canal pour commuter les signaux détectés entre les premier et second canaux dans des premier et second états de commutation et l'appareil comprend un moyen (90, 102) pour calculer l'estimation sous la forme de la solution à l'équation:

$$\text{estimation = tg}[1/2 \ \overset{N}{\underset{i=1}{\Sigma}} \ \ln \ \left|\frac{vi}{wi}\right| \ . \ P_i / \ \overset{N}{\underset{i=1}{\Sigma}} \ P_i]$$

où
N est le nombre de paires d'échantillons utilisés lors de l'estimation, et
$P_i$ est un poids déterminé par vi et wi,
le moyen de commutation commutant entre les canaux au cours du calcul de l'estimation de telle sorte que l'estimation est indépendante de la mauvaise correspondance dans le moyen de traitement de signaux, ledit moyen de calcul comportant une première mémoire morte programmable (90) stockant une première fonction de vi et wi, ledit moyen de calcul comportant une seconde mémoire morte programmable (102) stockant une seconde fonction de vi et wi, ladite valeur absolue de vi étant appliquée au réseau desdites première et seconde PROM sous la forme d'une adresse et ladite valeur absolue de wi étant appliquée au réseau desdites première et seconde PROM sous la forme d'autres bits d'adresses et ledit premier réseau PROM et ledit second réseau PROM fournissant des sorties à un accumulateur pour obtenir un rapport de:

$$\frac{1/2 \ \overset{n}{\underset{1}{\Sigma}} \ \ln \ \left|\frac{vi}{wi}\right| \ . \ P_i}{\overset{n}{\underset{1}{\Sigma}} \ P_i}$$

2. Appareil selon la revendication 1, dans lequel ledit moyen de calcul comporte une mémoire morte programmable pour stocker la tangente de la fonction.

3. Appareil selon la revendication 2, dans lequel ladite première fonction est la fonction 1/2 1n lvil / lwil.

4. Appareil selon la revendication 2, dans lequel ladite seconde fonction est la fonction Pi 1/2 1n lvil / lwil.

5. Appareil de traitement de signaux selon l'une quelconque des revendications 1 à 4, dans lequel ledit moyen d'échantillonnage comporte un premier convertisseur analogique-numérique pour échantillonner v(t) et produisant des échantillons numériques vi et un second convertisseur analogique-numérique pour échantillonner w(t) et fournissant des échantillons numériques wi.

6. Appareil de traitement de signaux selon l'une quelconque des revendications 1 à 5, comportant un moyen pour délivrer Pi sous la forme d'une valeur binaire 1 ou 0.

7. Appareil selon la revendication 6, dans lequel ledit moyen de délivrance comprend un moyen pour déterminer Pi de manière qu'il ait une valeur de 1 si la valeur lvil + lwil est supérieure à un niveau de seuil prédéterminé, lvil étant dans une plage prédéterminée et lwil étant dans une plage prédéterminée, et sinon qu'il ait une valeur de 0.

8. Appareil de traitement de signaux selon la revendication 7, dans lequel le moyen de calcul comporte un premier moyen formant mémoire morte programmable pour stocker les valeurs de 1/2 1n lvil / lwil et les valeurs des poids Pi et un multiplicateur/accumulateur pour accumuler les valeurs de 1/2 1n lvil / lwil lorsque Pi a une valeur de 1.

9. Appareil de traitement de signaux selon la revendication 8, dans lequel le moyen de calcul comporte en outre un second moyen formant mémoire morte programmable, sensible aux sorties du multiplicateur/accumulateur pour stocker la fonction tangente hyperbolique et un moyen formant compteur pour compter les échantillons pour lesquels Pi a une valeur de 1, ledit moyen formant compteur indiquant que la sortie dudit second moyen formant mémoire morte programmable est une estimation valable lorsqu'un nombre d'échantillons prédéterminé est atteint.

10. Appareil de traitement de signaux selon l'une quelconque des revendications 1 à 9, dans lequel ledit moyen de commutation de canal est sensible audit moyen formant compteur pour changer d'état lorsque la moitié du nombre d'échantillons prédéterminé est atteint.

11. Appareil de traitement de signaux selon la revendication 10, dans lequel ledit moyen de commutation de canal comporte en outre un moyen pour changer le signe de 1/2 1n lvil / lwil en fonction desdits premier et second états de commutation.

FIG. 1

ION BEAM 12

36 38 FIG.2

z

FIG.3

SENSOR 1 50 $v(t)$ → 54

SENSOR 2 52 $w(t)$ →

CHANNEL 1 56

CHANNEL 2 58

ADC 60 $v_i$ →

ADC 62 $w_i$ →

DIGITAL SIGNAL PROCESSOR 64 → $\hat{x}$

SAMPLING PULSE

TIMING AND CONTROL 66

EP 0 308 211 B1

FIG.4

EP 0 308 211 B1

FIG.5

FIG.6

SAMPLING PULSE

SIGN BIT

60

ADC

62

ADC

TO CHANNEL SWITCH 54

86

7

6

1

SIGN BIT

7

6

1

88

REVERSE SIGN

120

15

14

9

8

7

2

1

PROM

$(\pm \frac{1}{2} \ln \frac{|v_i|}{|w_i|})$

66

TIMING
AND
CONTROL

CLOCK AND
RESET

122

MULTIPLIER/
ACCUMUL-
ATOR

IN 1

IN 2

7

SIGN
BIT

1

ACCEPT/
REJECT BIT

124

SAMPLE
COUNTER

1

M STAGE

(M-I) STAGE

126

PROM
(TANH)

14

8

136

OUTPUT
REGISTER

$\hat{x}$

CLK

EP 0 308 211 B1

FIG. 7